# EUROPÄISCHE PATENTSCHRIFT

(11) **EP 0 513 557 B1**
(45) Veröffentlichungstag und Bekanntmachung des Hinweises auf die Patenterteilung: **05.08.1998**
(21) Anmeldenummer: 92106750.0
(22) Anmeldetag: 21.04.1992
(51) Int. Cl.: H01L 39/22, H01L 39/24

(54) **Supraleitendes Tunnelelement**
Superconducting tunneling device
Dispositif supraconducteur à effet tunnel

(30) Priorität: 17.05.1991 DE 4116120
(43) Veröffentlichungstag der Anmeldung: 19.11.1992
(73) Patentinhaber: Schröder, Hehrwart, 88662 Überlingen (DE)
(72) Erfinder: Schröder, Hehrwart, 88662 Überlingen (DE)
(74) Vertreter: Patentanwälte Eisele, Otten & Roth

(56) Entgegenhaltungen:
- EP-A- 0 449 559
- US-A- 4 334 158
- REVIEW OF SCIENTIFIC INSTRUMENTS Bd. 62, Nr. 1, Januar 1991, NEW YORK, US Seiten 156 - 162 Kurakado M. et al 'Superconductive radiation detector with large sensitive area (series-connected STJ detector)'

## Beschreibung

Die Erfindung betrifft ein supraleitendes Tunnelelement nach dem Oberbegriff des Anspruchs 1. Ein solches Tunnelelement ist bekannt aus DE-A-1 803 953.

Supraleitende Tunnelelemente detektieren elektromagnetische Strahlung im Gegensatz zu konventionellen Detektoren um mehrere Größenordnungen empfindlicher.

Als weiterer großer Vorteil ist die extrem kurze Ansprechzeit von supraleitenden Tunnelelementen zu nennen. Sie liegt heute in der Größenordnung von Pico-Sekunden (tmin ≥ e. Φ0/DELTA; wobei e = Elektronenladung, Φ0 = Flußquant und DELTA = Energielücke ist).

Supraleitende Tunnelelemente für Detektionszwecke gibt es schon seit etwa 25 Jahren. Cooper-Paar-Tunneln und Einzel-Elektron-Tunneln, (auch Quasiteilchen-Tunneln genannt) werden z.B. in der Radio Astronomie zur Detektion elektromagnetischer Wellen verwendet.

SQUID-Systeme werden in der Medizin und Forschung zur Präzisions-Messung elektromagnetischer Felder eingesetzt.

Supraleitende Tunnelelemente detektieren elektromagnetische Strahlung auf zwei verschiedene Arten: als Breitband-Detektor oder als frequenzselektiver Detektor.

Allgemein gilt für Tunnelelemente, daß eine Arbeits-Grenze in Richtung kleiner Wellenlängen existiert, die durch die Energielücke im Anregungsspektrum des Supraleiters vorgegeben ist.
Die Energielücke ist temperaturabhängig. Sie erreicht bei T = 0 theoretisch ihren größten Wert. Dies bedeutet, daß mit niedrigeren Temperaturen auch die kurzwellige Arbeitsgrenze immer weiter in Richtung kleinerer Wellenlängen verschoben wird.

Wegen der Abhängigkeit der Ansprechzeit und Schaltzeit von der Energielücke wird auch diese mit abnehmender Temperatur immer geringer. Mit abnehmender Temperatur nimmt darüberhinaus die Rauschtemperatur ab und die Empfindlichkeit zu.

Der Wert der Energielücke kann zum Beispiel mit einer Stromschleife zwischen den Werten des materialspezifischen und temperaturabhängigen Maximums bis zu Null gesteuert werden. Deshalb kann ab der kurzwelligen Grenze jedes Spektrum eingestellt werden **(DE-A-18 03 953)**.

Zwei verschiedene Tunneleffekte können für die Detektion elektromagnetischer Strahlung ausgenutzt werden. Die Dicke der Tunnel-Barriere bestimmt die Art des Effektes. Der prinzipielle Aufbau eines Tunnelelementes sind zwei oder mehrere durch eine Tunnel-Barriere getrennte Supraleiter. Bei Barrierendicken mit mehr als 1,5 nm bis etwa 3 nm können nur noch Einzelelektronen tunneln.

Bei Dicken um 1 bis 1,5 nm tunneln Cooper-Paare.

Reihenschaltungen mit mehr als 1000 Josephson-Tunnelelementen wurden gefertigt und untersucht. (J. Niemeyer und J.H. Hinken, Mikrowellen Magazin, Vol. 13 No. 2, 1987, Seite 118).

Aus der **EP 329 507 A1** ist ein supraleitendes Element bekannt, bei dem eine Vielzahl von Supraleitern und Tunnel-Barrieren aufeinander gestapelt sind. Die Supraleiter sind nur einige Atomlagen dick (Spalte 3, Zeile 58) und können mit Molekularstrahlepitaxie (Spalte 4, Zeile 20) aufgebracht sein. Elektrische Anschlüsse (z.B. für Steuerspannungen) innerhalb der Einzelschichten des Stapels sind nicht offenbart.

Aus der **US-Zeitschrift J.App. Phys. 59(11), 1986, Seite 3807** ist ein optischer Detektor mit einer supraleitenden Oxidschicht bekannt.

Aus den **Patent Abstract of Japan der JP 63-248187 (A)** ist ein Stapel supraleitender und normal leitender dünner Filme bekannt.

Aus den **Patent Abstracts of Japan** der **JP 2-5580 (A)** und der **JP 2-114576** sind supraleitende optische Detektoren bekannt, bei denen mehrere Supraleiter und Tunnel-Barrieren aufeinander gestapelt sind.

Aus den **Patent Abstracts of Japan** der **JP 62-210708 (A)** und der **JP 62-210709 (A)** sind Analog/Digital-Wandler bekannt, die aus Stapeln von Supraleitern unterschiedlicher Größe bestehen, die von Tunnel-Barrieren getrennt sind.

Aus der **US 4,837,604** ist ein supraleitender Schalter mit einem Stapel von Supraleitern bekannt, bei denen der Steuerstrom an eine in dem Stapel befindliche Schicht angelegt wird.

Aus der **DE 40 10 489 A1** ein supraleitendes Element bekannt, mit dem ein Sensor und ein Sender realisierbar sind, bei denen der Frequenzbereich einstellbar ist. Auch dieses Tunnelelement detektiert elektromagnetische Strahlung erst ab einer kurzwelligen Grenze in Richtung langwelliges Spektralgebiet.

Diese kurzwellige Grenze entspricht dabei energetisch dem jeweiligen Wert der Energielücke. Der Wert der Energielücke kann bei den Tunnelelementen zwischen den Werten des materialspezifischen und temperaturabhängigen Maximums bis zu Null gesteuert werden.

Aufgabe der Erfindung ist es, ein solches Element dahingehend zu verbessern, daß die Steuerbarkeit verbessert wird, so daß unter anderem im Detektionsmodus die Detektionsleistung und im Sendemodus die Strahlungsintensität vervielfacht werden.

Dies wird erfindungsgemäß erreicht von einem Element mit den Merkmalen des Anspruchs 1. Ausführungen der Erfindung sind Gegenstände von Unteransprüchen.

Das bisherige Element ist erfindungsgemäß dadurch verbessert, daß die Supraleiter integrierte, isolierte Steuerschichten enthalten. In einer Ausführung der Erfindung ist die Zahl der Tunnel-Barrieren und der Supraleiter erhöht, so daß "Stapel" vorliegen.

Die Anzahl der Supraleiter kann von Anwendung zu Anwendung unterschiedlich eingestellt sein. So ist die Anzahl der Tunnel-Barrieren zwischen 3, 4, 5, insbesondere über 10, und so weiter bis über 1000 beliebig einstellbar.

### Aufbau des erfindungsgemäßen Elementes

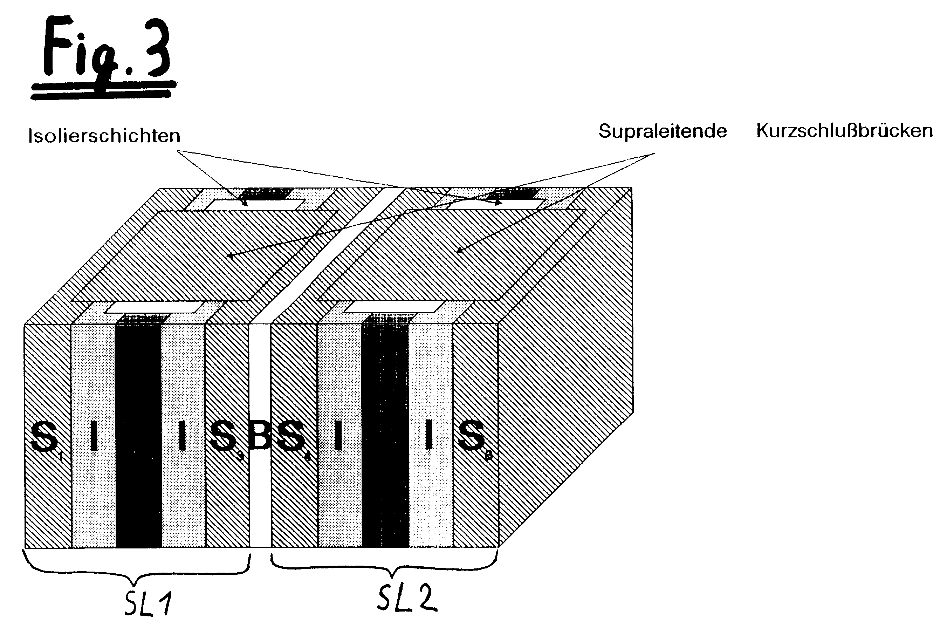

Auf einer Substratgrundplatte, die sich mit den zu verwendenden Materialien bezüglich der Gitterkonstanten verträgt, wird eine Schichtfolge aus Supraleitern und Tunnel-Barrieren angeordnet. Innerhalb jedes Supraleiters ist - isoliert - eine supraleitende Steuerschicht eingebaut. Ein erfindungsgemäßer Supraleiter (oder Tunnelzelle, in Fig. 3 als SL1 bezeichnet) hat also den Aufbau: Supraleitende Schicht S1 - Isolator I - supraleitende Schicht S2 zur Steuerung - Isolator - supraleitende Schicht S3. Es folgt dann die Tunnel-Barriere B und der nächste Supraleiter SL2. An diesen schließt sich die Tunnel-Barriere B2 an und dann wieder ein Supraleiter (eine solche Tunnelzelle) u.s.w..
Die Anzahl der Supraleiter (Tunnelzellen) im Tunnelsystem ist abhängig von den Fertigungsmöglichkeiten und vom Anwendungs-Ziel. Sie kann groß sein. Jeder Supraleiter ist von der nächsten durch eine definierte Tunnel-Barriere getrennt. Deshalb gibt es in diesem Tunnelkontakt viele Tunnel-Barrieren.

### Zu den Schichtdicken

Die Supraleiter sollen so dünn sein wie es die Funktionsfähigkeit der Supraleitung zuläßt. (Z.B. bei Hochtemperatursupraleitern in der Grössenordnung nm).
Die Isolatoren an den Flanken der supraleitenden Steuerschichten müssen das Tunneln unterbinden und sind deshalb bevorzugt um 5 nm dick.
An die Tunnel-Barrieren werden die höchsten Anforderungen gestellt. Sie müssen alle geschlossen (dicht) sein und sollen eine Dicke um 1 bis 1,5 nm haben.

Die der Strahlung zugewandte Schichtenfolge soll die Bedingung der optisch dünnen Schicht erfüllen. Das heißt, die Supraleiter müssen viel kleiner als die Wellenlänge der Strahlung sein, mit der man arbeiten will. Die Supraleiter müssen mindestens die Dicke der materialspezifischen Kohärenzlänge erreichen. Das bedeutet, daß der ganze Stapel eine Dicke in der Größenordnung Mikrometer hat. Wegen der sehr dünnen Schichten ist selbst der ganze Stapel nur eine dünne Folie.

Wie bei einem Einzeltunnelelement haben alle Supraleiter je einen Anschluß für die Spannungsversorgung und je einen für den Signalstrom, damit alle Kombinationen mit dem Bauelement möglich werden. Um für jeden Supraleiter die Energielücke steuern zu können, muß in jeden Supraleiter eine Stromschleife gelegt werden. Diese Stromschleife besteht aus einer gegenüber der Umgebung isolierten supraleitenden Folie.
Zwei sich gegenüberliegende Flanken des Tunnelstapels sollen bevorzugt von allen Kontaktierungen frei bleiben.

### Arbeitsweise des Bausteins mit mehreren Supraleitern

Wie bei einer Reihenschaltung wird die Spannung mit jedem weiteren Supraleiter aufsummiert, wobei zwischen jedem Supraleiterpaar die ursprüngliche Energielückenspannung von 2 DELTA anliegt. Wenn entsprechend der resultierenden Kontaktspannung die Tunnelschaltung bis kurz vor dem Kennlinien-Anstieg vorgespannt wird, wird in allen Tunnel-Barrieren detektiert, bei etwas größerer Vorspannung, im Sendemodus, wird in allen Tunnel-Barrieren gesendet.

Der Tunnelbaustein mit mehreren Supraleitern leistet die aus der **DE 40 10 489 A1** bekannten Spezifikationen. Gegenüber dem einfachen Tunnelelement bietet der erfindungsgemäße Mehrfachtunnel-Baustein im Stapel unter anderem folgende deutliche Vorteile:
Das supraleitende Mehrfachtunnelelement, bestehend aus der neuen Schichtfolge der Tunnelzellen im Stapel, ist in dieser Form neu. Die sich aus jeder Anordnung ergebenden Folgerungen sind vor allem homogene Felder in jeder supraleitenden Schicht. Dies ermöglicht eine individuelle gleichmässige Steuerung der Energielücke in jedem Supraleiter und schließlich beliebige Kombinationen aller möglichen Schaltungen. Das gestapelte Mehrfachtunnelelement wird da durch zu einem überlegenden Instrument.

Die wichtigsten Vorteile des neuen Bauelementes gegenüber den bisherigen Tunnelelementen sind im Folgenden:
- **Homogene Felder in jedem Supraleiter**
   Bisherige Tunnelelemente arbeiten mit einer Steuerschicht an einem Ende des Tunnelelementes. Damit ist eine gleichmäßige Steuerung schon beim einfachen Tunnelelement nicht möglich.
   Die neue Schichtfolge arbeitet mit supraleitenden Steuerschichten in jedem Supraleiter. Die strominduzierten Felder durchfluten jeden Supraleiter gleichmäßig von der Mitte her. Diese gleichmäßige, homogene Durchflutung ist Voraussetzung für die volle Steuerfähigkeit des Stapels.
- **Summierung der Detektorleistung**
   Wenn die Arbeitsspannung die Bedingung für den Detektionsmodus erfüllt (Arbeitsspannung kleiner 2 DELTA), und alle Supraleiter mit gleichen Energielücken gesteuert werden, dann wird sich mit jedem Supraleiter die Detektionsleistung abzüglich der Rauschleistung, (die mit etwa Quadratwurzel zwei pro Schicht wächst) summieren.
- **Gleichzeitiges Detektieren verschiedener Frequenzen**
   Wenn N = Anzahl der Supraleiterpaare ist, dann werden im Detektionsmodus N verschiedene Frequenzen gleichzeitig detektiert, wenn jedes Supraleiterpaar verschiedene Energielücken hat. Die N verschiedene Frequenzen können individuell eingestellt werden.
- **Summierung der Strahlungsintensität**
   Wenn die Arbeitsspannung die Bedingung für den Sendemodus erfüllt (Arbeitsspannung größer 2 DELTA), und alle Supraleiter mit gleichen Energielücken gesteuert werden, dann wird sich mit jedem Supraleiter die Strahlungsintensität summieren.
- **Gleichzeitiges Senden auf verschiedenen Frequenze**n
   Wenn N = Anzahl der Supraleiterpaare ist, dann werden im Sendemodus N verschiedene Frequenzen gleichzeitig gesendet, wenn jedes Schichtpaar verschiedene Energielücken hat. Die N verschiedene Frequenzen können individuell eingestellt werden.
- **Kombination beliebiger Frequenzen**
   Da jeder Supraleiter und jedes Supraleiterpaar einzeln gesteuert werden kann, gibt es zwischen den Optionen - "alle Supraleiter gleiche oder alle Supraleiter verschieden Energielücken" - die Option der beliebigen Kombinationen. Damit können beispielsweise mehrere Supraleiterpaare für gewünschte ausgesuchte Frequenzen gebündelt werden.
- **Bau von hochempfindlichen SQUID-Systemen**
   Für den Einsatz in SQUID-Systemen müssen die einzeln steuerbaren Supraleiterpaare so geschaltet werden, daß alle Supraleiter im Stapel bei gleicher Energielücke arbeiten. Dann wird das Ausgangssignal des SQUID-Systems um Größenordnungen stärker. Die Empfindlichkeit wird durch die Stapelanordnung deutlich besser.

### Fertigung und Kontaktierung

Fertigung und Kontaktierung können bevorzugt mit Hilfe der Molekularstrahlepitaxie erfolgen **(DE 40 10 489 A1)**. Dabei entsteht die ganze Sensorzelle einschließlich der Kontaktbahnen zu den Kontaktierungsanschlüssen in der Molekularstrahlepitaxieanlage. Die Kontaktierung wird durch das Verfahren der rekursiven Überlappung während der Schichtensynthese gelöst.

Hierzu wird auf der Substratplatte die erforderliche Anzahl von Kontakten bereitgehalten.

Da die Bauelementfläche Ausdehnungen in der Größenordnung Millimeter hat, die Kontaktbahnen aber kleiner als Mikrometer werden, kann zum Beispiel durch Mikroschablonen die Geometrie der Schichten stufenweise der Anzahl der erforderlichen Kontakte angepaßt werden.

Bei den Hochtemperatursupraleitern ist die Kohärenzlänge viel kleiner als bei den klassischen Supraleitern. Diese Tatsache kommt dem Ziel entgegen, die supraleitenden Schichten nur so dick wie nötig zu fertigen. (Die Mindestausdehnung eines Supraleiters muß gleich der Kohärenzlänge sein, weil sonst keine Supraleitung möglich ist).

Die Erfindung wird anhand von sechs Figuren näher erläutert.

Es zeigen:
- Fig. 1: schematisch ein erfindungsgemäße Tunnelelemente,
- Fig. 2: ein Detail aus Fig. 1,
- Fig. 3 und 4: zwei Supraleiter, wie sie in einem erfindungsgemäßen Tunnelelement verwendbar sind,
- Fig. 5: ein Schaltschema eines erfindungsgemäßen Tunnelelements und
- Fig. 6: schematisch ein multispektrales Sende- und Empfangssystem in einem Cassegrainspiegel.

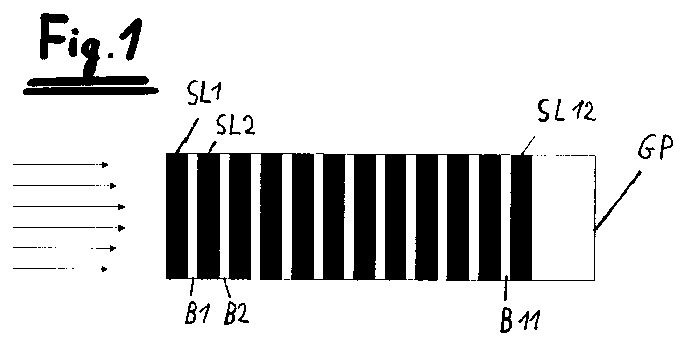

Fig. 1 zeigt schematisch ein erfindungsgemäßes supraleitendes Tunnel-element, bei dem auf einer Substratgrundplatte **GP** zwölf Supraleiter **SL1** bis **SL12** aufgebracht sind, die von elf Tunnel-Barrieren **B1, B2** usw. getrennt sind. Elektrische Anschlüsse sind in dieser Fig. noch nicht gezeigt. Die Zählung der Supraleiter **SL1, SL2** usw. beginnt an der Seite, die der Substratgrundplatte **GP** entfernt liegt. Auf dieser Seite (links) tritt auch bei Sensorbetrieb die Strahlung ein oder tritt bei Betrieb als Strahlungsquelle die Strahlung aus. Die Dicken der Tunnel-Barrieren **BN** liegen hier bei 1 bis 1,5 nm, die der Supraleiter **SLN** müssen mindestens der Kohärenzlänge des Supraleiters (materialabhängig) entsprechen. Die Kohärenzlänge ist die kleinste Länge, über die die Cooper-Paardichte variieren kann.

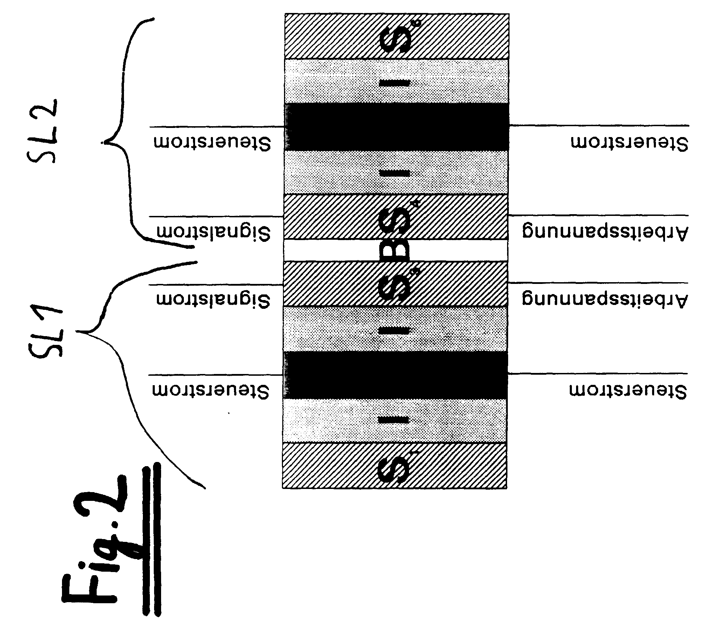

Fig. 2 zeigt den Aufbau der zwei von der Tunnel-Barriere **B** getrennten Supraleiter **SL1** und **SL2** der Fig. 1 im Detail. Die Supraleiter **SL1** und **SL2** enthalten je zwei supraleitende Schichten **S1, S3** und **S4, S6** und haben jeweils in ihrer Mitte je einen supraleitenden Steuerfilm **S2, S5**. Dieser Steuerfilm **S2** ist gegen seine übrige supraleitende Umgebung isoliert (isolierende Schichten **I**). An den Steuerschichten **S2, S5** liegt der Steuerstrom an, an den supraleitenden Schichten (hier **S3** und **S4**) sind Anschlüsse für die Arbeitsspannung und für den Signalstrom vorhanden.
Die Steuerschicht ist zum Steuern eines homogenen Feldes in jedem Supraleiter **SL** vorhanden. Die Steuerschichten (Steuerfilme) **S2, S5** können entweder siebartig sein oder die anliegenden supraleitenden Schichten **S1, S3** müssen an den Flanken kurzgeschlossen sein (in unserem Beispiel **S1** mit **S3** und **S4** mit **S6**). Auf diese beiden Weisen sind die Einzelschichten **S1** und **S3** räumlich getrennt, aber elektrisch leitfähig miteinander verbunden.
Die Isolatoren **I** haben eine Dicke > 5 nm.

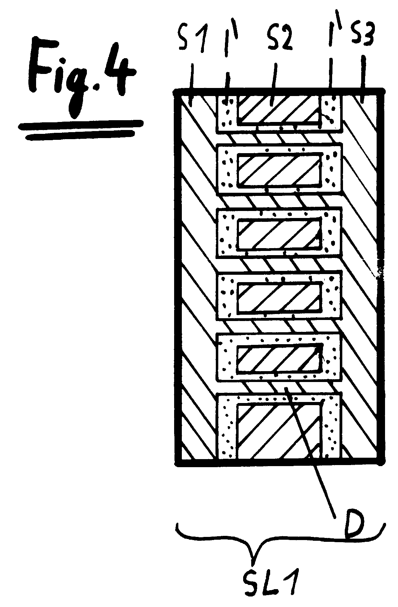

Fig. 3 und 4 zeigen zwei mögliche Realisierungen der räumlichen Trennung, aber der elektrischen Verbindung der supraleitenden Einzelschichten **S1** und **S3**.
Fig. 3 zeigt supraleitende Kurzschlußbahnen an den Flanken des Elements, hier gezeigt sind die zwei von der Tunnel-Barriere **B** getrennten Supraleiter **SL1** und **SL2**. Die voneinander getrennten supraleitenden Schichten **S1** und **S3** bzw. **S4** und **S6** sind hier an den Flanken mittels supraleitender Kurzschlußbrücken elektrisch kurzgeschlossen. Die Kurzschlußbrücken sind dabei von den Steuerschichten **S2** und **S5** elektrisch isoliert (Isolierschichten an den Flanken).

Fig. 4 zeigt eine andere Ausführung des Supraleiters **SL1**, bei der die elektrische Verbindung der supraleitenden Einzelschichten **S1** und **S3** über die Durchgriffe **D** erfolgt. Die Steuerschicht **S2** ist dadurch gelocht oder siebartig. Die Durchgriffe **D** sind ebenfalls supraleitend, bevorzugt aus dem gleichen Material wie die Schichten **S1** und **S3** und sind von der Steuerschicht **S2** elektrisch isoliert (Isolierungen **I'**).

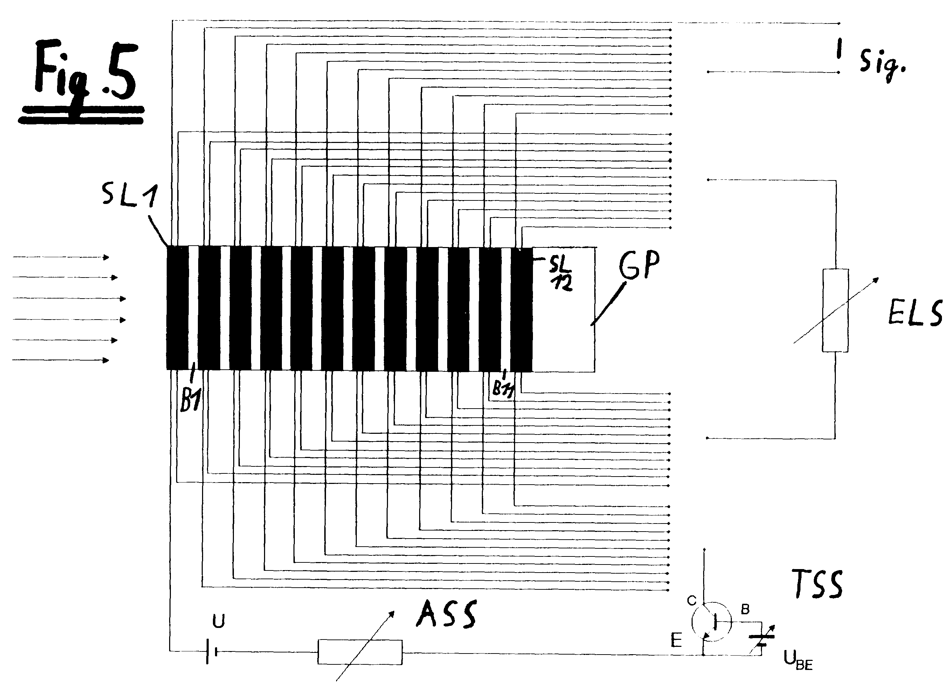

Fig. 5 zeigt ein Schaltschema eines erfindungsgemäßen supraleitenden Mehrfach-Tunnelelements, hier z.B. mit zwölf Supraleitern **SL1** bis **SL12**, die von elf Tunnel-Barrieren **B1** bis **B11** getrennt sind, auf einer Grundplatte **GP**. Die einzelnen Supraleiter **SLN** haben seitliche Anschlüsse, wie in Fig. 2 gezeigt, mit denen sie aktiviert oder desaktiviert werden können, so daß die resultierenden Tunnelspannungen beliebig eingestellt werden können (Tunnelspannungssteuerung **TSS**). Gezeigt ist auch die Stromschleife **ELS**, mit der eine elektromagnetische Zusatzsteuerung der einzelnen Energielücken ermöglicht ist. Gezeigt ist auch die Arbeitsspannungssteuerung **ASS**. Die Einfallsrichtung der Strahlung beim Sensorbetrieb ist durch die Pfeile links angedeutet. Beim Betrieb als Strahlungsquelle tritt die Strahlung links aus.

Jeder Supraleiter **SLN** hat in dieser Ausführung also vier Anschlüsse: Zwei für die Arbeitsspannung und den Signalstrom **I**_{**sig**} und zwei für die Stromschleife **ELS** zur Energielückensteuerung.

### Steuerung des Mehrfachtunnel-Bausteins

- **Einstellen des Betriebsmodus**
   Die Arbeitsspannung entscheidet über den Betriebsmodus Detektieren, parametrisch Verstärken und Senden. Dies wird mit einer Präzisions-Spannungsquelle eingestellt.
- **Steuerung der Intensität in Stufen und stufenlos**
   Die Steuerung der Intensität erfolgt am nichtlinearen Teil der Strom-Spannungskennlinie durch Steuerung des Tunnelstromes stufenlos und durch Abschalten der einzelnen Supraleiter **SLN** in Stufen.
   Die Intensität im Sendemodus bzw. die Detektionsleistung kann durch (supraleitende) Schalter (Josphson-Element mit Steuerschicht) zwischen den stillzulegenden Supraleitern **SLN** in Stufen gesteuert werden. Dies kann z.B. an den Aussenflächen durch Zu- oder Abschalten geschehen. Diese (supraleitenden) Schalter können über einen Rechner je nach Bedarf aktiviert oder desaktiviert werden.
   Die Tunnelschaltung darf in ihrem Innern nicht durch stillgelegte Supraleiter **SLN** unterbrochen werden.
   Die stufenlose Steuerung der Intensität kann durch Steuerung des Tunnelstromes erfolgen. Bis zum Einsatz supraleitender Bauelemente kann z.B. eine Transistor-Schaltung - in Reihe mit der Präzisions-Spannungsquelle geschaltet - diese Aufgabe erfüllen.
   Im linearen der Strom-Spannungskennlinie sollte ein linearer Widerstand die Arbeitsspannung steuern. Im nichtlinearen Kennlinien-Bereich ändert sich die Arbeitsspannung ganz wenig aber der Tunnelstrom steigt hier steil an. Wegen der nichtlinearen Kennlinien-Felder des Transistors läßt sich deshalb damit ein geeignetes Steuerelement zum stufenlosen Steuern des Tunnelstromes realisieren.
- **Elektromagnetische Steuerung der Energielücke**
   Die Energielücken in den einzelnen Supraleitern **SLN** können durch elektromagnetische Felder einheitlich oder individuell von Null bis Maximum gesteuert werden, die von einer supraleitenden Steuerschleife **ELS** erzeugt werden.
   Will man alle Kombinationen des Bauelementes ermöglichen, ist es erforderlich, alle Supraleiter **SLN** einzeln mit einem speziellen Stromnetz zu versehen. Dieses Stromnetz muß inmitten jeder Schicht so beschaffen sein, daß ein annähernd homogenes Feld auf die supraleitenden Schichten einwirken kann. Zwei mögliche Lösungen sind in den Fig. 3 und 4 gezeigt (Kurzschlußbrücken oder siebartig isolierte supraleitende Schicht inmitten der supraleitenden Einzelschichten **SN)**.
- **Rechner-Steuerung**
   Die genannten Funktionen dieses Mehrfachtunnel-Elementes können von einem Rechner kontrolliert und gesteuert werden. Die Überwachung und Steuerung aller genannten Funktionen erfolgt mit Hilfe spezieller Programme.

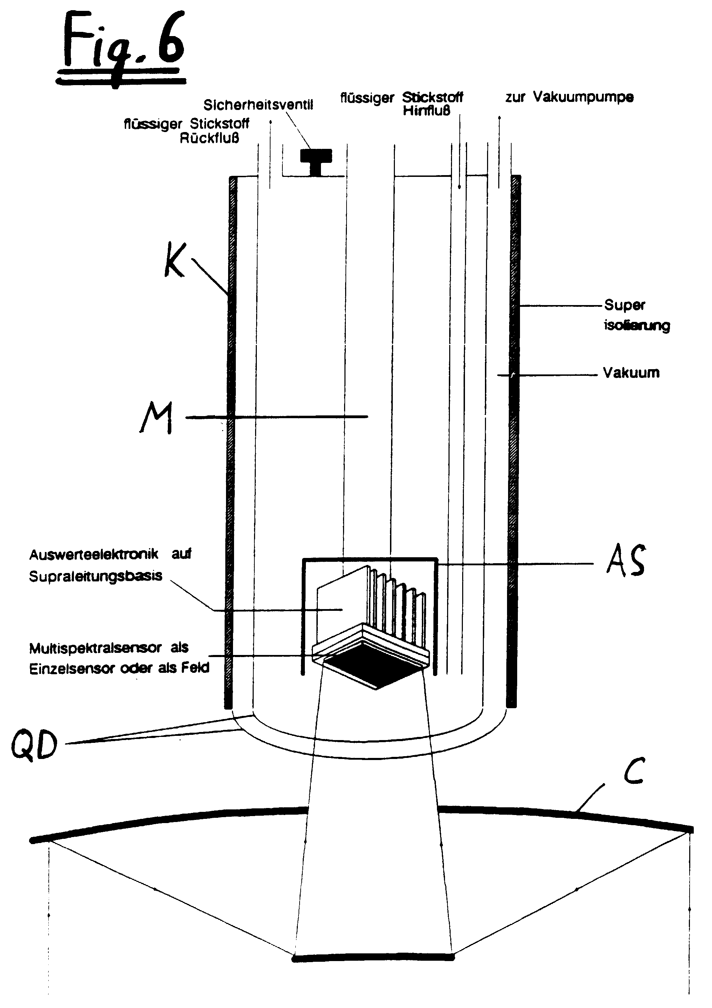

Fig. 6 zeigt das Schema eines multispektralen Sende- und Empfangssystems in einem Cassegrainspiegel **C**. Der als Einzelsensor ausgebildete oder aus Sensorelementen zusammengesetzte Sensor mit Steuer- und Auswerte-Elektronik befindet sich hier im Kryostaten **K** im Brennpunkt des Cassegrain-Spiegels **C**. Das Sensorfeld besteht aus vielen nebeneinander angeordneten Einzeltunnelelementen, wobei jeweils die das Licht aufnehmenden Supraleiter (in Fig. 1 **SL1**) nach unten gerichtet sind, so daß das zur detektierende Licht über den Spiegel **C** in die nebeneinander liegenden Supraleiter **SL1** der einzelnen Tunnelelemente eintritt. Vom Kryostaten K sind die Superisolierung, der Vakuumanschluß, der Zufluß und der Rückfluß für den flüssigen Stickstoff, das Sicherheitsventil, der Montagehalter **M** mit Steuer- und Signalleitungen, die Abschirmung **AS** auf Supraleitungsbasis und der Quarzdom **QD** gezeigt. In diesem miniaturisierten Kryostat **K** ist sichergestellt, daß alle supraleitenden Teile bei jeder Lage im Raum im flüssigen Stickstoff bleiben.
Wichtige Teile sind Sicherheitsventile, Superisolation und ungehinderter Zu- und Abfluß. Die Mikrowellenstrahlung fällt durch den Dom **QD** auf den Sensor. Der miniaturisierte Kryostat **K** kann damit schwenkbar ausgebildet werden, wodurch der Sensor in beliebige Richtungen gerichtet werden kann.

Für viele Anwendungen wird diese "flüssige Stickstoffversion" genügen.
Für extreme Anforderungen kann eine Erweiterung mit einem nicht gezeigten Helium-Kryostaten erfolgen. Diese arbeitet dann mit einem zusätzlichen Strahlungsschild aus flüssigem Stickstoff.

### Anwendungen des erfindungsgemäßen Mehrfachtunnel-Bausteins

Diese stichwortartige Auflistung vermittelt einen Eindruck von den interessanten Möglichkeiten, die dieser Baustein mit seiner Flexibilität bietet:
- Analyse von Signalen:
   Wegen der sehr hohen Zeitauflösung und hoher Empfindlichkeit ist eine Feinanalyse im ganzen elektromagnetischen Spektrum möglich.
- Identifizierung von Signalquellen:
   Signalquellen haben charakteristische Muster, die nach Vergleich mit einem Emitterkatalog im Rechner identifiziert werden kann.
- Radar-Technik bei freier Wahl des Spektral-Bereiches ab einer kurzwelligen Grenze in Richtung langwelliges Gebiet.
- Passive Zielerkennung und Zielverfolgung ab einer kurzwelligen Grenze in Richtung langwelliges Gebiet.
- Radar für zerstörungsfreie Prüfung.
   Wegen der Frequenzabhängigkeit der Absorption durchdringt Radiostrahlung z.B. einige Meter Erdreich, teilweise Staubwolken.
   Das konsequente Anwenden des Prinzips der frequenzabhängigen Absorption, gekoppelt mit hoher Empfindlichkeit auf den nahezu wichtigsten Spektralbereich des elektromagnetischen Spektrums führt z.B. zu folgenden weiteren Anwendungen:
- passive Ortung von Zielen:
   - Auffinden von Verunglückten und Vermißten unter Trümmern, Wasser, Schnee, Fahrzeugen, Schiffen nach Unfällen usw.
   - Unterstützung bildgebender Verfahren im Infrarot. (Für Medizin und Werkstoff-Prüfung) Kontrastreiche Bilder im IR-Bereich sind wegen des Durchfahrens eines jeweils optimalen Spektrums möglich.
   - Verschiedene Spektralbereiche machen verschiedene Schichten sichtbar.
   - Diagnoseunterstützung in der Medizin mit nichtinvasiven Verfahren.

Die zu analysierenden Moleküle werden zur Rotationsbewegung mit z.B. Mikrowellen angeregt. In vielen Fällen reicht ein Rotations-Übergang aus, da es aufgrund der geringen Linienbreite (= 10 kHz) kaum Überlappungen verschiedener Substanzen gibt.

So ist es z.B. möglich, durch gezielte Impuls-Strahlung des supraleitenden Mehrfachtunnel-Bausteins von etwa 1 µs Dauer und einer Frequenz in der Nähe des zu beobachtenden Rotations-Überganges, alle möglichen Substanzen und Verbindungen anzuregen, damit sie dann ihr eigenes Rotations-Spektrum emittieren.

Die zeitlich abklingenden Emissions-Signale würden dann in Abständen von wenigen 10 ns abgetastet und per Rechner verarbeitet werden. (In der Literatur sind z.B. die Rotations-Spektren von mehr als 1500 Verbindungen dokumentiert).

### Anwendungen für die Kombination beliebiger Frequenzen

Makromoleküle lassen sich leichter zerstören, wenn man sie gezielt mit mehreren nur solchen z.B. IR-Frequenzen gleichzeitig bestrahlt, für die Teilmoleküle Resonanzen haben.
Für die elektronische Kampfführung bietet sich die multispektrale Sensor- und Sende-Technik geradezu an.

### Anwendungen zum Bau von hochempfindlichen SQUID-Systemen

Bei Verwendung der erfindungsgemäßen Tunnelelemente wird das Signal um viele Größenordnungen stärker, nämlich um die Anzahl der supraleitenden Schichten **N**. Dies gilt, wenn alle Schichten **SLN** auf exakt gleicher Energielücke arbeiten.

## Patentansprüche

1. Supraleitendes Tunnelelement mit dem Aufbau Supraleiter (**SL1**), Tunnel-Barriere (**B**), Supraleiter (**SL2**), **dadurch gekennzeichnet,** daß die Supraleiter (**SLN**) jeweils zwei räumlich voneinander getrennte, aber elektrisch miteinander verbundene supraleitende Schichten (**S1, S3**) enthalten, zwischen denen eine mittels Isolatoren (I) isolierte supraleitende Steuerschicht (**S2**) angeordnet ist, wobei die Isolatoren (**I**) für die Steuerschicht ein Durchtunneln verhindern und wobei die Steuerschicht elektrische Anschlüsse zur veränderlichen Steuerung der Energielücke in dem jeweiligen Supraleiter (**SLN**) aufweist.

2. Supraleitendes Tunnelelement nach Anspruch 1, **dadurch gekennzeichnet,** daß drei oder mehr (**N**) von zwei oder mehr (**N-1**) Tunnel-Barrieren (**BN**) getrennte Supraleiter (**SLN**) mit integrierten isolierten Steuerschichten (**S2, S5**) aufeinander gestapelt sind, so daß jeweils eine Tunnel-Barriere (**BN**) zwischen je zwei aufeinanderfolgenden Supraleitern (**SLN**) angeordnet ist.

3. Supraleitendes Tunnelelement nach Anspruch 1 oder Anspruch 2, **dadurch gekennzeichnet,** daß die jeweils leitfähig miteinander verbundenen supraleitenden Schichten (**S1, S3**) über supraleitende Kurzschlußbrücken, die gegen die entsprechenden Steuerschichten (**S2**) isoliert sind, oder über isolierte Durchgriffe (**D**), die den Steuerschichten (**S2**) ein siebartiges Aussehen geben, miteinander verbunden sind.

4. Supraleitendes Tunnelelement nach einem der vorhergehenden Ansprüche, **dadurch gekennzeichnet,** daß die Dicke der Tunnel-Barrieren (**B**) für das Elektronen-Tunneln um 3 nm liegen und für das Josephson-Tunneln bei ungefähr 1 bis 1,5 nm liegen.

5. Supraleitendes Tunnelelement nach einem der vorhergehenden Ansprüche, **dadurch gekennzeichnet,** daß zumindest die Tunnel-Barrieren (B) durch Molekularstrahlepitaxie aufgebracht ist.

6. Sensor oder Strahlungsquelle für elektromagnetische Strahlung beliebiger Wellenlänge, insbesondere vom Infrarot (IR)-Bereich und mm-Wellen bis in das langwellige Gebiet mit einem supraleitenden Tunnelelement eines der Ansprüche 1 bis 5, wobei die Schichten (**SLN**) für die entsprechende Strahlung durchlässig sind.

7. Empfänger oder Sender für akustische Wellen, insbesondere im Ultraschallbereich- und Hyperschallbereich mit einem supraleitenden Tunnelelement eines der Ansprüche 1 bis 5.

8. Supraleitendes Bauelement für SQUID's oder Rechner mit einem supraleitenden Tunnelelement eines der Ansprüche 1 bis 5.

## Claims

1. Superconducting tunnel element with the structure superconductor **(SL1)**, tunnel barrier **(B)**, superconductor **(SL2)**, **characterised in that** the superconductors **(SLN)** comprise respectively two spatially separated but electrically connected superconducting layers **(S1, S3)**, between which a superconducting control layer **(S2)** is arranged which is insulated by means of insulators **(I)**, in which the insulators **(I)** for the control layer prevent tunnelling and the control layer comprises electrical connections for the variable control of the energy gap in the respective superconductor **(SLN)**.

2. Superconducting tunnel element according to claim 1, **characterised in that** three or more **(N)** superconductors **(SLN)** separated by two or more **(N-1)** tunnel barriers **(BN)** and having integrated insulated control layers **(S2, S5)** are stacked so that one tunnel barrier **(BN)** is arranged between two consecutive superconductors **(SLN)** respectively.

3. Superconducting tunnel element according to claim 1 or claim 2, **characterised in that** the superconducting layers **(S1, S3)** connected to one another in a conducting manner are joined together by superconducting shorting bridges insulated from the corresponding control layers **(S2)** or by insulated penetration passages **(D)** which give the control layers **(S2)** a sieve-like appearance.

4. Superconducting tunnel element according to one of the preceding claims, **characterised in that** the thickness of the tunnel barriers **(B)** for the electron tunnelling is about 3 nm and for the Josephson tunnelling about 1 to 1.5 nm.

5. Superconducting tunnel element according to one of the preceding claims, **characterised in that** at least the tunnel barrier **(B)** is applied by molecular beam epitaxy.

6. Sensor or radiation source for electromagnetic radiation of any wavelength, in particular from the infrared **(IR)** range and mm waves up to the longwave range with a superconducting tunnel element of one of claims 1 to 5, in which the layers **(SLN)** are permeable to the corresponding radiation.

7. Receiver or transmitter for acoustic waves, in particular in the ultrasonic and hypersonic range with a superconducting tunnel element of one of claims 1 to 5.

8. Superconducting component for SQUIDs or computers with a superconducting tunnel element of one of claims 1 to 5.

## Revendications

1. Elément tunnel supraconducteur, comportant un supraconducteur (SL1), une barrière-tunnel (B), un supraconducteur (SL2),
caractérisé en ce que les supraconducteurs (SLN) comportent, à chaque fois, deux couches supraconductrices (S1,S3), séparées spatialement l'une de l'autre, mais reliées électriquement l'une à l'autre, entre lesquelles est prévue une couche de commande (S2) supraconductrice isolée par des isolants (I), les isolants (I) pour la couche de commande empêchant un effet tunnel et la couche de commande présentant des raccords électriques pour la commande variable de la lacune d'énergie dans le supraconducteur respectif (SLN).

2. Elément tunnel supraconducteur selon la revendication 1,
caractérisé en ce que trois ou plus (N) supraconducteurs (SLN) séparés par deux ou plus (N-1) barrières-tunnels (BN), ayant des couches de commande isolées intégrées (S2,S5), sont empilés l'un sur l'autre, de sorte que, à chaque fois, une barrière-tunnel (BN) est agencée entre deux supraconducteurs (SLN) successifs.

3. Elément tunnel supraconducteur selon la revendication 1 ou la revendication 2,
caractérisé en ce que les couches supraconductrices (S1,S3) reliées à chaque fois l'une à l'autre de façon conductrice sont reliées l'une à l'autre par l'intermédiaire de courts-circuits supraconducteurs, qui sont isolés par rapport aux couches de commande correspondantes (S2), ou par l'intermédiaire de passages isolés (D), qui fournissent aux couches de commande (S2) un aspect de tamis.

4. Elément tunnel supraconducteur selon une des revendications précédentes,
caractérisé en ce que l'épaisseur des barrières-tunnels (B) pour l'effet tunnel à électrons vaut 3nm et pour l'effet tunnel Josephson environ 1 à 1,5 nm.

5. Elément tunnel supraconducteur selon une des revendications précédentes,
caractérisé en ce qu'au moins les barrières-tunnels (B) sont appliquées par épitaxie à rayonnement moléculaire.

6. Capteur ou source pour un rayonnement électromagnétique de longueur d'onde quelconque, en particulier dans le domaine des infrarouges (IR) et d'ondes millimétriques jusque dans le domaine des grandes ondes, ayant un élément tunnel supraconducteur d'une des revendications 1 à 5, les couches (SLN) étant transparentes pour le rayonnement correspondant.

7. Récepteur ou émetteur pour des ondes acoustiques, en particulier dans le domaine ultrasonore et dans le domaine hypersonore, comportant un élément tunnel supraconducteur d'une des revendications 1 à 5.

8. Module supraconducteur pour des systèmes SQUID ou des calculateurs ayant un élément tunnel supraconducteur d'une des revendications 1 à 5.
